# EUROPEAN PATENT SPECIFICATION

(11) **EP 2 732 477 B1**
(45) Date of publication and mention of the grant of the patent: **23.11.2016**
(21) Application number: 11735844.0
(22) Date of filing: 14.07.2011
(51) Int. Cl.: H01L 31/18, H01L 21/768

(54) **A METHOD OF ASSEMBLING A SOLAR PANEL**
EIN VERFAHREN ZUM ZUSAMMENFUEGEN EINES SOLARPANELS
PROCEDE POUR ASSEMBLER UNE PLAQUE SOLAIRE

(43) Date of publication of application: 21.05.2014
(73) Proprietor: Eurotron B.V., 2971 VL Bleskensgraaf (NL)
(72) Inventor: DEN HARTIGH, Simon, NL-2969 AZ Oud Alblas (NL); VERSCHOOR, Jan, NL-3366 BG Wijngaarden (NL); BAKKER, Jan, NL-2971 BD Bleskensgraaf (NL)
(74) Representative: Nollen, Maarten Dirk-Johan
(86) International application number: PCT/EP2011/062064
(87) International publication number: WO 2013/007311

(56) References cited:
- EP-A1- 2 141 973
- WO-A1-2005/015638
- US-A1- 2011 076 847

## Description

### FIELD OF THE INVENTION

The invention relates to a method of assembling of a solar panel, wherein a plurality of solar cells is assembled to a first side of a interconnect foil comprising a pattern of electrical conductors, the pattern being provided with contact pads.

The invention also relates to a resulting solar panel.

### BACKGROUND OF THE INVENTION

The manufacture of solar panels requires the assembly of solar cells. This assembly establishes electrical connections between the solar cells and an interconnect foil, and provides a mechanically stable and well protected body. In comparison to assembly processes for integrated circuits, the size of a solar panel is impressive, as it can easily have dimensions of several square meters. This evidently requires specific handling. In comparison to assembly processes of displays, a major difference resides in the integration of a plurality of solar cells next to each other, so as to cover the surface as good as possible. On the one hand, displays are typically based on a single display component. More displays may be arranged adjacent to each other, but then the distance between them is less of a concern. On the other hand, in solar panels, any space between individual cells results in efficiency losses. Additionally, the solar panel needs to be flat in view of its use integrated in housing constructions or directly on top of a roof. Cables and flex foils and such large scale connectors are therefore not appropriate in the assembly of solar cells. Furthermore, its use outside at locations that are exposed to sunlight, but that further may be exposed to ice and wind, requires that a solar panel needs to be able to accommodate large temperature differences, and hence differences in thermal expansion.

An assembly line for assembly of solar cells is for instance known from the manuscript 'A novel module assembly line using back contact solar cells' as published on the IEEE Photovoltaics Specialists Conference, San Diego, USA, from May 11-15, 2008, authors M. Späth, P.C. de Jong, I.J. Bennett, T.P. Visser and J. Bakker. The assembly line presented therein is suitable for handling extremely thin and fragile solar cells with thicknesses of less than 200 microns and even less than 150 microns. The assembly line allows an assembly process comprising the steps of as outlined above. After the provision of an interconnect foil (referred to as a conductive back sheet foil), conductive material in the form of paste is deposited on the electrical conductors of the interconnect foil. A pre-processed sheet of thermoplast material, such as polyethylenevinylacetate (EVA) is hereon provided. Then, the solar cells are assembled to the thermoplast material. Use is made of a pick and place unit for adequate positioning. It further allows coupling of the cells to the conductive material. After provision of a further sheet of thermoplast material and a cover plate, the solar panel is laminated in a vacuum laminator while simultaneously forming connections between the contact pads of the solar cells and those of the interconnect foil. The module assembly line is capable of assembling solar panels comprising 4 x 9 and 6 x 10 solar cells, each solar cell having a size of 156 x 156 mm² (6 x 6 inch). The assembly line is designed for supporting any type of solar cells provided with contact pads at its rear side. Examples of such solar cells include Integrated Back Contact (IBC), Heterojunction with Intrinsic thin layer (HIT), Emitter Wrap Through (EWT), Metallisation Wrap Through (MWT), Metallisation Wrap Around (MWA) solar cells.

The known assembly line of Eurotron comprises a plurality of stations. In a first station the interconnect foil is provided to a carrier table. The carrier table is movable by means of a transport system so as to move the stack of foils through the stations. The carrier table is provided with vacuum means. In a second step, conductive material, such as conductive adhesive, is applied, for instance with screen printing. The subsequently provided first foil is provided with through-holes in locations aligned to those of the conductive material. In a subsequent station precise alignment is achieved between the contact pads of the solar cells and the through-holes in the first foil. The aligned solar cells are then positioned onto the contact pads. Further stations are designed for applying the second foil and the cover plate and for flipping the solar panel upside down. Thereafter, it is placed into a vacuum laminator. The station for the flipping of the solar panel comprises a clamping system to avoid shifting or breakage of solar cells. Use of the assembly line provided good results in terms of yield (100%) and performance (small deviation from the average).

It is a limitation of the Eurotron's known assembly line that it is not suitable for integration of further components, such as power converters, drivers and other active devices, suitably in the form of integrated circuits, capacitors, resistors, inductors. Such integration is clearly interesting for enhancing the functionality of the solar panel, and needs to be integrated on the solar panel level, as the solar cell comprises merely a single wafer of silicon. Defining integrated circuits within the solar cell would increase manufacturing costs of the solar cells considerably if not dramatically. It would therefore be beneficial to allow integration of such components or a circuit thereof into the solar panel, but it is not clear how to achieve this within the context of the known method and corresponding assembly line.

A method for manufacturing multi-foil systems that have an electric function, i.e. flexible laminated electronic or optic function, for instance a solar panel function is known from EP2141937A1. The method comprises the provision of a conductive structure between two foils in a multi-foil system and comprises the steps of providing at least one solid state adhesive layer on a foil; patterning the adhesive layer with through-holes; filling the through-holes with conductive material, so as to form the conductive structure, connected to the terminal and bonding the at least two foils. The patterning can be done by a laser, but other patterning techniques such as punching and embossing are possible as well.

WO2005015638A1 discloses a process for manufacture of a solar cell foil using a temporary substrate. The solar cell foil is made in a sequence of steps comprising the provision of an etchable temporary substrate; the application of a front electrode of a transparent conductive oxide; the application of a photovoltaic layer; the application of a back electrode layer, the application of a permanent carrier; the application of a resist on top of the etchable substrate, and the selective removal of the etchable temporary substrate by etching.

### SUMMARY OF THE INVENTION.

It is therefore an object of the present invention to provide a method as recited in the opening paragraph which further allows assembly of electronic components into the solar panel, without decreasing yield of the assembly process and without endangering the ability to withstand differences in temperature during use of the solar panel.

The invention relates equally to a solar panel according to the independent device claim 9.

Further objects relate to an assembly line suitable for carrying out said method.

The object is achieved in a method of assembling of a solar panel according to the independent claim 1, wherein a plurality of solar cells is assembled to a first side of a interconnect foil comprising a pattern of electrical conductors, the pattern being provided with some contact pads, which interconnect foil is provided with a protective layer on a second side facing away from the solar cells. This method comprises the steps of:
- applying the interconnect foil onto a carrier table provided with an access window;
- locally removing the protective layer through the access window so as to expose at least one of said contact pads of the interconnect foil,
- assembling at least one electronic component to the second side of the interconnect foil, contact pads of the components being coupled to corresponding ones of said exposed contact pads of the interconnect foil.

The object is also achieved in a solar panel as claimed in Claim 9.

The use of an access window allows the arrangement of the optical removal means to a stationary frame of one of the stations of the assembly line. Such relatively or even completely fixed position of the optical removal means enables optimum resolution due to an adequate calibration.
The access window moreover defines a limited area within the interconnect foil, as a result of which it is suitably used for detection of the actual position of the interconnect foil on the mobile carrier table and/or for deposition of material in a limited area only. It may further be used for fixing the position of the mobile table relative to a station.

The local removal of the protective layer of the interconnect foil may be applied relatively before the provision of further layers and solar cells on top of the interconnect foil. However, it is not excluded to carry out the local removal at a later stage, for instance simultaneously to one of the further steps, for instance the failure detection step.

The assembly of the at least one component is suitably carried out at a late stage in the assembly process, for instance just before or after the lamination step. At this stage, the mobile carrier table has already been removed. Hence, the components to be applied can have any size. In one suitable implementation, the at least one electronic component is assembled prior to the lamination step. The lamination step may then simultaneously result in a proper connection of the electronic component to the conductors in the interconnect foil, for instance by laminating with a suitable heat treatment. In another suitable implementation, the assembly of the at least one electronic component is carried out separately from the manufacture of the semi-manufactured solar panel.

Rather than assembling an electronic component, the exposed contact pads could be protected against humidity and/or contamination during transport and logistics with a cover. The cover is suitably a sheet of electrically insulating material. The sheet does not need to extend over the complete surface area of the panel. Preferably, the cover is applied so as to be removable.

The assembly line suitably comprises a plurality of stations, corresponding to assembly steps. The solar panel under construction is herein moved between individual stations while being present on the mobile table. In one example process, a first station is a deposition station for the interconnect foil to the mobile carrier table. In the second station, the protective layer is locally removed. In the third and further stations, further foils and the solar cells are provided on top of the interconnect foil. In again a further station, failure detection is carried out. The following step is a first heating step, so as to ensure that all foils stick together, which is followed in the subsequent step by a turning process, in which the mobile carrier table ends up at the top and may be removed subsequently. Then the component will be assembled and the assembly will be laminated and finished. It will however be clear to the skilled person that this process may be varied. For instance, while each step is suitably carried out in a separate station, it is not excluded that one station is used for a plurality of steps, or that for certain steps the station is moved rather than the mobile table. Further variations are described in the following embodiments.

In one embodiment, the local removal from the protective layer is carried out from the bottom side. However, it is not excluded to do this from the top side, even though the bottom side appears to give a better positioning stability, as the position of the optical removal means can be controlled better.

In another embodiment, the heating and turning steps could be left out, and the device is directly laminated. However, this has the disadvantage that the mobile carrier is also shifted into the kiln, which is not deemed beneficial.

In a further embodiment, one of the foils, particularly of encapsulant material, is provided with holes prior to its application on the interconnect foil. This is beneficial, since misalignment of holes relative to the corresponding pads in the interconnect foil may be limited. However, it is not excluded that such holes are provided after application of the foil on the interconnect foil.

In the preferred embodiment, the interconnect foil is provided in the first step on top of the mobile carrier table. However, it is not excluded to use the reverse order, wherein the interconnect foil is assembled to the stack of foils and the solar cells. It however appears more difficult in such case to ensure a proper alignment of the interconnect foil to all solar cells.

In a suitable embodiment, the positioning of the interconnect foil on the mobile carrier table occurs with a vision system. Preferably, the interconnect foil is applied to the carrier table, after which it is laterally shifted so as be located in the desired position. The position herein includes both a two-dimensional position of a reference location as well as an angle (or the position of a second reference location). After that the interconnect foil has been applied in the correct position, the position is fixed relative to mobile carrier table. One suitable implementation thereof, is the provision of vacuum in the mobile carrier table.

After moving the mobile carrier table to a subsequent station, the mobile carrier table is aligned with respect to the station by means of an indexing system. In a specific example, use is made of a mechanical system, wherein portions of the station are coupled to the carrier table in accordance with predefined positions. Most preferably, use is made of a coupling based on complementary shapes. The portions of the stations may be pins inserted into cavities defined in the table, or hollow parts fit to protrusion of the mobile carrier cable. The mobile table could be provided with any ridge or edge, and the portion of the station fitting thereto. Suitably, said portions of the station are movable in a direction perpendicular to the movement direction of the mobile carrier table, for instance a vertical direction or a horizontal y-direction, the mobile carrier table moving in the x-direction. Coupling could be provided in both directions.

Preferably, the portions are constituted for making a vertical movement. In a further implementation, cavities in the mobile carrier table intended for the alignment and fixing in a station could have the form of windows, one of which could be the access window. In such embodiment, care is needed so as to prevent that the said portions of the station entering into such windows do not damage the interconnect foil. One implementation thereto is the provision of such portions with protective tips.

In an alternative implementation, the access window is provided with a circumferentially located cavity or protrusion in the mobile carrier. A hollow pin can be mechanically coupled to this circumferential cavity or protrusion. The optical removal means may then be active within said hollow pin. This implementation offers additional safety so as to ensure a correct location of the mobile table relative to the optical removal means. Moreover, in case the optical removal means are a laser, this ensures that the radiation of the laser will be encapsulated and not be able to spread in any fashion.

This fixing of the mobile carrier table in a predefined position turns out to be suitable for mutual alignment of foils. Any further foil to be applied to the interconnect foil is preferably provided on a carrier table, which will be aligned with respect to the mobile carrier table and/or other features within the station. On the basis of any detection of the position of the interconnect foil relative to the mobile carrier table, the positioning of any further carrier table may be tuned so as to correct (minor) misalignments. The provision of such further foil on a further carrier table has the advantage that there is no risk of bubbling or other undesired deformation of such a further foil in the process of applying it to the interconnect foil. The further carrier table ensures that the foil is undeformed, e.g. planar. The use of vacuum for the attachment of such further foil to the further carrier table has the advantage that the transfer of the further foil to the interconnect foil may be carried out smoothly, e.g. by removal of the vacuum in a desired speed, and optionally gradually, such that the transfer occurs portion-wise rather than at once.

In a further embodiment, the access window in the mobile carrier table may be used for alignment detection. For instance, the alignment detection through the access window may be carried out at a higher resolution than the preceding alignment and positioning procedure. This is however not deemed necessary.

In again a further embodiment, the mobile carrier table comprises more than a single access window. Such presence of more than one access window would allow an improved alignment detection. Primarily, it allows to provide through-holes in the protective layer at more locations, and hence to a larger design freedom.

Further embodiments will be defined in the description and/or the claims

### BRIEF DESCRIPTION OF THE DRAWINGS

These and other aspects of the invention will be further elucidated with reference to the figures, in which:
Fig. 1 shows in a diagrammatical cross-sectional view a solar panel of a first embodiment in accordance with the invention; herein each layer and component is shown separately;
Fig. 2 shows in a diagrammatical cross-sectional view a step in the manufacturing method of the invention;
Fig. 3 shows in a diagrammatical cross-sectional view the solar panel after carrying out the step shown in Fig. 2, and
Fig. 4 shows the assembly line for use in the invention comprising in one station the step shown in Fig. 2.

The Figures are not drawn to scale and intended for illustrative purposes only, and diagrammatical in nature. Equal reference numerals in different Figures refer to equal or corresponding parts.

### DEFINTIONS

The carrier table as used in the present invention preferably comprises a mobile carrier table suitable for moving said stack of foils in different stages of said method between stations for carrying out steps of the method. In one embodiment, it is provided with vacuum means for local application of vacuum. It is observed for clarity that the term 'vacuum' as used in the context of the present invention refers to a situation of controlled underpressure relative to the atmospheric pressure. Suitably, this pressure is 1 promille (0.1 %) or less of the atmospheric pressure as known to the skilled person in the art. A suitable mobile carrier table comprising means for generating a vacuum - a vacuum generator - is for instance known from EP-A 2182549, which is included by reference herein. This known mobile carrier table is provided with vacuum chambers that allow the limitation of the vacuum to selected areas only (e.g. also referred to herein as local application of vacuum). In a most preferred implementation disclosed in EP-A 2182549 use is made of a vacuum generator comprises one venturi device, and an overpressure tank is present. The venturi device is provided with a suction side and a pressure side, of which the suction side is connected to an aperture in the mobile carrier table. The pressure side is connected to the overpressure tank. Such a mobile carrier table is typically made of metal such as steel or aluminum and intended for reuse.

The term 'station' as used in the present application will be used interchangeably with 'assembly station' and is particularly referred to a station, wherein the moving of the mobile carrier table is interrupted and wherein typically one step in the assembly method is carried out. The term 'assembly line' herein refers to an assembly equipment comprising a plurality of assembly stations. In a preferred embodiment, the device to be assembled is transported from one to a following assembly station by means of a mobile carrier table.

The term 'local removal' of the protective layer refers to a removal of the protective layer such that an underlying contact pad is at least partially exposed. The underlying contact pad may be completely exposed, but this is not deemed necessary or beneficial. In one embodiment, the protective layer is removed such that the edge of the remaining protective layer falls within the edge of the contact pad. This embodiment is beneficial for minimizing risk of short circuitry. The local removal is particularly a such a removal so as to maintain an insulating barrier between neighbouring contact pads that are in operation coupled to different voltages.

The term 'encapsulant material' is herein used most broadly as a material known from the field of packaging of semiconductor components and similar electronic components. It may be a material suitable for use in underfill purposes, for the application of a layer on the rear side of a slice of semiconductor material, as an encapsulating material (such as a polyimide). It is preferably elastic, but its structure and properties may be subject to change in any of the heat treatments. More specifically, the material is flowable, i.e. as an underfill type material upon heating to a desired temperature, so as to fill any gaps between individual electronic components. While the first and second foils of encapsulant material are shown hereinafter to be applied separately, it is not excluded that at least one of these foils is applied to a surface of an adjacent layer prior to the integration into the solar panel 30.

### ELABORATED DESCRIPTION OF AN ILLUSTRATIVE EMBODIMENT

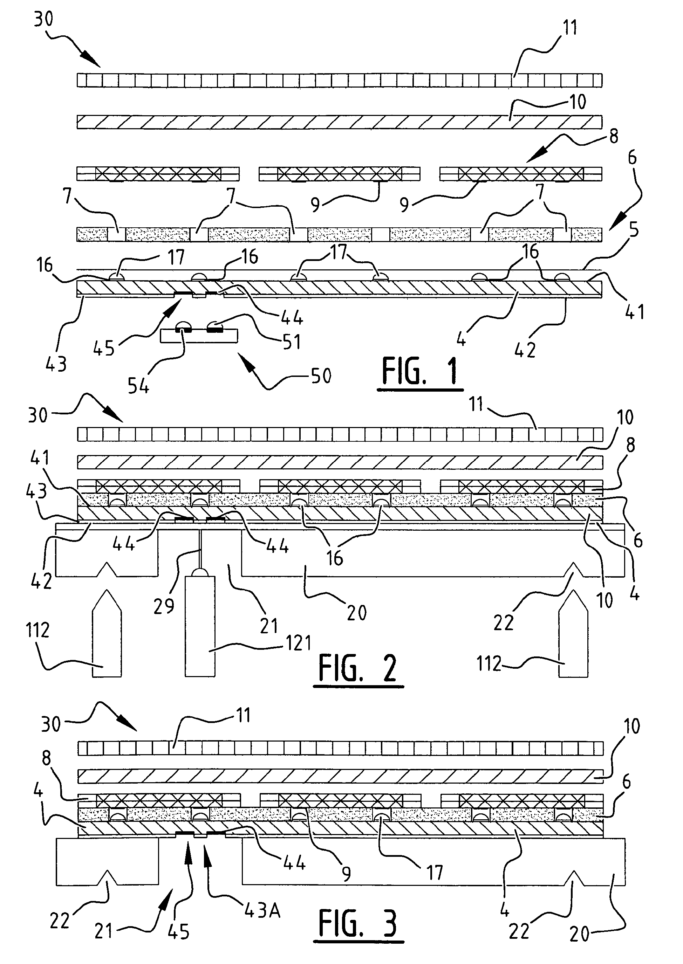

Fig. 1 shows in a diagrammatical and cross-sectional view a solar panel 10 of a first embodiment in accordance with the invention. The solar panel 30 is shown, for reasons of clarity, in a semi-manufactured state, wherein the individual layers 4, 6, 8, 10 and 11 have not yet been laminated together and the electronic component 50 is not yet assembled to the solar panel 30. The solar panel 30 thus comprises a stack of foils including an interconnect foil 4, on a first side 41 thereof a first foil of encapsulant material 6 (one example is a polymer based on ethylene vinyl acetate), a second foil of encapsulant material 10 and a cover plate 11. The interconnect foil is provided with a protective layer 43 on its second side 42, i.e. faing towards the carrier table 20 (see Fig. 2 and 3). A plurality of solar cells 8 is present between the first foil 6 and the second foil 10. The first foil 6 is provided with through-holes 7, that are aligned with contact pads 16 on the interconnect foil 4 and contact pads 9 on the solar cells 8. Electrically conductive material 17 is provided on the interconnect foil 4 on top of the contact pads 16. The first and second foil 6, 10 of encapsulant material are suitably chosen so as to get adhesive upon gentle heating, so that the semi-manufactured solar panel 30 can be handled as a single unit, and particularly be turned upside down. The first and second foil 6, 10 moreover are most suitably materials that will flow around the solar cells 8 upon further heating. It is not strictly necessary that both the first and the second foil 8, 10 will flow out. The through-holes 7 are suitably formed by punching as explained in the patent application EP2110213A1.

The protective layer 43 is patterned with through-holes 45 so as to expose contact pads 44 on the second side of the interconnect foil 4. The through-holes 45 are provided at locations corresponding to the contact pads 54 of the electronic component 50. A portion 43A of the protective layer 43 - see Fig. 3 - is retained between neighbouring through-holes 45. As will be explained hereinafter, this portion 43A serves as an electrical isolation.

In one example, the one or more electronic components are integrated into a module to be assembled to the interconnect foil. Thereto, the protective layer of the interconnect foil is locally removed at a location aligned with the contact pads. The module 50 may provided with a carrier having a first side and an opposite second side. An encapsulation is provided on the first side, in which the electronic components (not shown) of the module 50 are encapsulated. Contact pads 54 (not shown) are exposed on the first side of the carrier outside the encapsulation. Electrically conductive material 51 establishes a connection between the module 50 and the contact pads 44 of the interconnect foil 4.

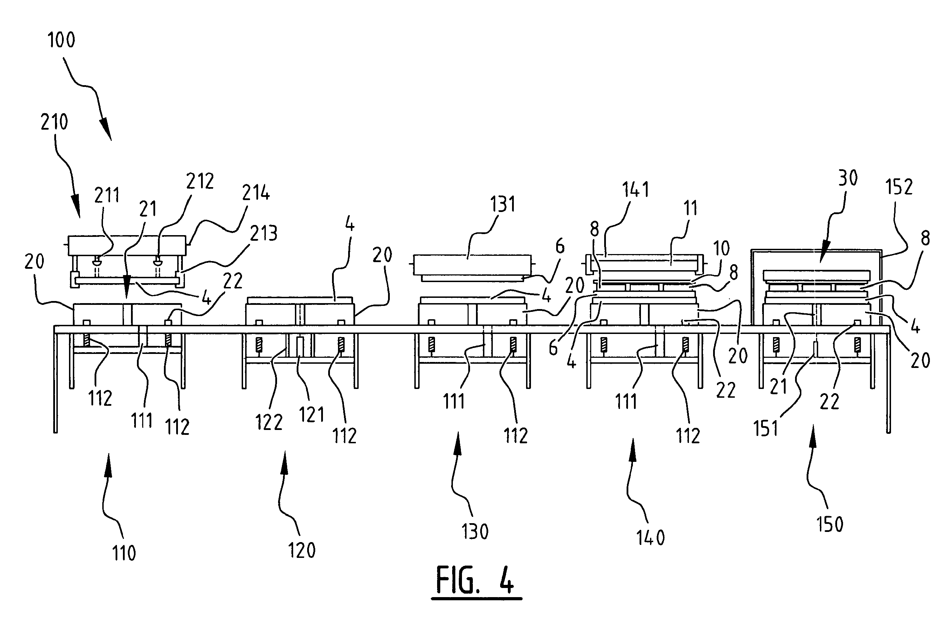

The solar panel 30 is built up step-wise, for technical reasons staring at the interconnect foil 4. In the following, the different steps will be discussed one after the other. During assembly, the solar panel 30 (i.e. the stack of foils) is aligned and presented to the assembly line by the carrier table. The stack 30 of foils remains on the carrier table 20 until it is ready for lamination. Prior to lamination, the solar panel 30 is removed from the carrier table 20, which moves back towards the entry of the assembly line 100 (as shown in Fig. 4).

The interconnect foil 4 is typically a material also known as a flexible PCB that generally contains an epoxy or tape (f.i. polyimide based) material. Such flexible PCB is known in the art and is built up of a plurality of layers. The protective layer 43 as used in the context of the present invention is typically one unpatterned layer of the flexible PCB, but may alternatively be a separate layer. The pattern of its conductors is preferably defined prior to the deposition. The interconnect foil 4 typically has a size at least corresponding to the size of the solar panel 30.

Other processes for defining the interconnect foil 4 are not excluded. Rather using a very large PCB as the interconnect foil 4, the interconnect foil 4 may for instance comprise a number of PCBs that are arranged adjacent to each other. An separate foil may be used for mechanically integrating such PCBs. Such separate foil is for instance an electrically insulating foil, or could be a printed circuit board (PCB) of a lower resolution. An electrical connection could be provided in known manner, for instance with electrically conductive adhesive. Alternatively, the PCBs could be operating independently, and optionally be coupled together externally to the laminate. The holes to the contact pads may at the second bottom side allow such external coupling. In order to position such plurality of PCBs appropriately, for instance on top of a foil covering the mobile carrier table, an intermediate station may be added to the assembly line.

Fig. 2 shows the solar panel 30 while being processed so as to remove the protective layer 43 locally. Fig. 3 shows the solar panel 30 after this step. Both Figures show that the interconnect foil 4 is processed while being present on a carrier table 20, which is in one important embodiment a mobile carrier table. The mobile carrier table 20 is provided with an access window 21. The mobile carrier table 20 is furthermore provided with fixing features 22, in this case shown as cavities into the mobile carrier table 20. The mobile carrier table 20 may be positioned in a station of the assembly line by mechanical coupling of pins 112 to the fixing features 22. Alternatively embodiments of mechanical couplings between complementary elements 112 and 22 can be envisaged by a skilled person in the field of mechanics. Furthermore, alternative positioning principles could be applied rather than the mechanical coupling, as known to the skilled person in the art of semiconductor equipment.

As shown in Fig. 2, the protective layer 43 is processed with an optical removal means 121, which is in this example a laser. Radiation 29 is transmitted by the laser 121 to the protective layer 43 through the access window 21.

Fig. 4 shows a diagrammatical cross-sectional view of the assembly line 100 for use in the method of the present invention. A plurality of stations 110, 120, 130, 140 and 150 is shown in this example, which is not intended to be limiting, but rather to be illustrative. The assembly line 100 is provided with a rail 101 which guides the mobile carrier table 20 from one station to a subsequent one. As will be explained, the interconnect foil is suitably attached to the mobile carrier table 20 by means of vacuum. This vacuum is maintained while the mobile carrier table 20 moves from one station to a subsequent one. Thereto, a plurality of stations is provided with means 111 for maintenance of the vacuum (typically a sufficient underpressure) within the mobile carrier table 20. A more specific embodiment thereof is shown in EP2182549A1 which is incorporated herein by reference.

Fig. 4 shows a series of mobile tables 20 present on the rail 101 in the different stations 110, 120, 130, 140, 150. It is observed for clarity that the assembly line 100 allows the processing of several solar panels 30 simultaneously. In one of the last stations (not-shown) the mobile carrier table 20 is suitably removed from the solar panel 30 and returned to the entry of the line 100. The return may be guided through a separate rail which is not shown in Fig. 4.

At a first station 110 which may be a manual work station, the interconnect foil 4 is deposited manually, or with robots, or with an apparatus 210 that supports the operator. The apparatus 210 has a body 214 that is movable, typically both in the vertical direction and the at least one lateral direction. It is for instance mechanically supported by a frame and hangs onto a rail. A gripper system 213 is present for carrying the interconnect foil. Various constructions could be used for the gripper system 213. As shown in the figure, use could be made of a plurality of grips at side faces. Alternatively, use can be made of a carrier to which the interconnect foil is attached. In view thereof, that the interconnect foil needs to be deposited on top of the mobile carrier table 20, such carrier will be present at the top side. Attachment of the foil to the carrier thus requires a specific mechanism, such as magnetic interaction, vacuum or the like. In a further alternative, the apparatus 210 could be provided with a roll of interconnect foil, which is then rolled out on the mobile carrier table 20.

An automatic lay up station for the interconnect foil 6 may be used alternatively. Use is made of a robot for picking up individual interconnect foils from a storage pile. Two storage positions are provided, enabling the lay up station to swap to another pile of interconnect foils as soon as the previous one is gone.

Each interconnect foil suitably passes a digital vision system, that is typically based on at least two cameras 211, 212. The digital vision system images the interconnect foil for optical alignment. Depending on the results, the robot or the operator will receive re-calculated coordinates for deposition of the interconnect foil 4 upon the carrier table 20, resulting in a technical alignment that is adequate for the interconnect foil 4. These coordinates may be stored and used for positioning of the mobile carrier table after a move to a subsequent station. The deposition using re-calculated coordinates may be carried out in the form of a shifting of the interconnect foil 4 on the mobile carrier table 20. After the deposition of the interconnect foil upon the carrier table using the re-calculated coordinates, the position of the interconnect foil may be fixed relative to the mobile carrier table. While a mechanical type fixing is not impossible, use is preferably made of vacuum.

As shown in this Fig.4, the mobile carrier table 20 is provided with cavities 22, with which it can be fixed within the station. Thereto, the station is provided with pins 112 (shown outside the cavities 22 for clarity), which can be moved upwards and downwards. In order that a vacuum can be applied to the mobile carrier table 20, the mobile carrier table 20 is suitably hollow, and at its top side provided with a plurality of holes, so as to attract the foil. The hollow mobile carrier table 20 may be subdivided into different chambers, for better control and reliability. Further means may be present within the mobile carrier table 20, such as an overpressure tank and venturi devices. Moveover, a vacuum generator 111 is present in the first station 110. The vacuum generator 111 can be decoupled from the mobile carrier table 20, so as to allow movement of the mobile carrier table 20. During the movement, the vacuum is maintained, even though some leakage may occur. Therefore, each subsequent station, prior to the pre-heating station 150 suitably comprises a vacuum generator 111. It will be clear that - in one implementation - the vacuum generator 111 could be left out in one or more stations, dependent on the speed of leakage on the duration of transport and operations.

In a second phase, the mobile carrier table 20 moves to the next station 120, wherein protective layer (not shown in this Figure) of the interconnect foil 4 is locally removed. After arrival at the next station 120, the mobile carrier table 20 is fixed to a predefined position using a fixture 122/22, particularly in a mechanical manner, so as to ensure that the position of the mobile carrier table 20 in the station 120 is correct. This process is repeated at the subsequent stations 130, 140, 150. While the local removal of the protective layer is shown herein as the second station 120, it is not excluded that this removal is carried out at a later stage in the process.

In the shown embodiment, the mobile carrier table 20 is provided with an access window 21. The access window is preferably a hole in the mobile carrier table 20. Alternatively, the access window 21 may be an optically transparent portion of the mobile carrier table 20, such that radiation may be transmitted through the mobile carrier table 20. However, an access hole is preferred, as this allows placement of the one or more electronic components 50, and as it disturbs the radiation least. An optical removal means 121 is coupled to a stationary frame of the second station 120. It is positioned such that its radiation can pass the access window 20 to arrive at the protective layer of the interconnect foil 4. This implementation has the advantage that the optical removal means 121 can have a well-defined lateral and vertical position, which need calibration only once or regularly. Therewith the distance to the protective layer is known, such that the focussing can be very precise.

In a preferred embodiment, the optical removal means 121 is a laser, such that the protective layer is removed by laser ablation. The laser may be provided with a rotatable head so as to shine on different portions of the protective layer individually, and therewith create holes that overlie the contact pads at least substantially overlapping. As a primary option, each hole individually overlies one contact pad. This ensures that there will be appropriate electrical isolation between the contact pads, whatever the voltage level such contact pads have. However, as a secondary option, one or more holes may overlie more than one contact pad, or more than one hole may be coupled to a single contact pad. In an alternative implementation, more than a single laser may be provided. The use of a laser 121 in combination with the access window 21 has the advantage that the access window 21 can be used as a laser shield. Such a laser shield is required for safety purposes so as to prevent that the intense laser light could unintentionally harm people. An additional laser shield 122 is shown in this Figure 4 in addition to the access window 21. The need for such an additional laser shield 122 depends on actual design implementations. It is observed that the use of a laser system for patterning of a layer in a solar cell that is incorporated in a processing station so as to irradiate the solar cell from the bottom side, is known from US2011/0076847.

While the laser is suitably fixed to a stationary frame, it is not excluded that the frame is provided with means for bringing the laser at a location nearer to the mobile carrier table, or even with the laser head within the access window.

Suitably, the distance between the light source, e.g. the laser, and the interconnect foil is in the order of up to 1.5 meters, for instance in the range of 10 mm to 0.7 meters, more specifically from 25 mm to 100 mm. Typically, the mobile carrier table has a thickness in the order of 20 mm up to 70 mm, for instance between 25 and 50 mm. In one implementation the light source is moved towards the interconnect foil after that the mobile carrier table has been provided in the station, from a rest position to an active position, in which the protective layer will be removed. The active position may then be at a distance to the interconnect foil that is substantially equal to or smaller than the thickness of the mobile carrier table, for instance 10-50 mm, for instance 20-40 mm. The rest position will be at a larger distance, so as to prevent damage to the light source during movement of the mobile carrier table. Such movement from rest position to active position may occur by means of rotation or by means of translation, or even a combination thereof. It is considered advantageous in the context of this implementation, that the station is provided with means for positioning the light source into its active position. This is for instance a mechanical element that meets the size of a body of the light source. Such means may alternatively be in the form of a plate or a block, to which the body of the light source is lying when in the active position. A plate is for instance considered suitable when moving the light source by means of rotation from its rest position to its active position. The light source may be at a distance just larger than the thickness of the mobile carrier table.

In one embodiment, the optical removal means will be provided with the stored coordinates of the interconnect foil relative to the mobile carrier table, or with an appropriate portion of such coordinates. Based thereon, in combination with knowledge of the design of the interconnect foil, the optical removal means, or a processor coupled thereto, is in a position to determine specifically the position of the contact pad to be exposed, and hence the needed orientation of the (rotatable) head of the optical removal means, e.g. laser.

In accordance with a further embodiment, an optical detector (not shown) may be present at a location aligned with the access window 21. Such an optical detector could be used for a high resolution detection of the lateral position of the contact pads. Contact pads typically have a diameter in the order of 50 micron to 500 microns. The distance between individual contact pads is typically of the same order as that of the diameter. In order to prevent short-circuits, and to achieve a low resistance, it is highly relevant to remove that portion of the protective layer, which substantially overlies a contact pad. An optical detector is used in this embodiment to calibrate and/or tune the light source and its orientation. The optical detector would receive light emitted from a light source, for instance the laser but alternatively a separate light source, and reflected at the interconnect foil.

It is not excluded that the access window 21 is used for the overall alignment detection, rather than doing alignment detection and positioning in the first station 110. Carrying out alignment detection through the access window 21 may be particularly interesting, if the interconnect foil 4 is applied to the mobile carrier table 20 in a different manner than indicated above, which does not allow detection and/or positioning of the interconnect foil 4 in the first station 121 to a sufficient resolution.

In a further implementation of this embodiment, a second access window (not shown) may be provided into the mobile carrier table 20, so as to verify the positioning in at least two areas across the mobile carrier table 20. (either to verify the exact orientation and/or to check expansion of the interconnect foil). The location of such second access window is preferably such that there is no need for implementation of two separate vision systems or for translating the vision system itself. E.g. one would arrive from the first access window 21 at the second access window merely through movement of the mobile carrier table 20, typically in one direction only. If a translation of the vision system is required, then suitably merely in a single direction substantially perpendicular to the movement direction of the mobile carrier table 20.

In a further embodiment, the access window 21 in the mobile carrier table 20 is used for the printing or deposition of materials before or after the local removal of the protective layer. The access window 21 effectively defines a frame such that deposition or printing of materials can be carried out on a limited area on the interconnect foil, rather than on the complete area. This printing or deposition would be suitably carried out in a separate station. It is most likely that the mobile carrier table is thereto turned, so as to print or deposit said materials downwards, but certain forms of contactprinting, moulding and the like allow an upside-down depositioning.

In one embodiment, the printing or deposition is carried out selectively, so as to define a pattern within the access window. Techniques for such selective deposition or printing comprise microcontactprinting and other forms of soft lithography, selective deposition or printing after surface modification, high-resolution (e.g. on the scale up to 100 microns, for instance 10-100 microns) inkjet printing.

When depositing or printing a material after the local removal of the protective layer, such material is particularly an electrically conductive material, such as a (conductive) adhesive or a solder paste, or a suitable surface layer for improved adhesion thereto, such as a inkjet printing of a silver-based composition. The deposition or printing of such materials within the access window prevents contamination of other areas of the interconnect foil herewith. In one implementation hereof, the protective layer may be a hydrophobic material or be provided with a hydrophobic surface layer. The printing or deposition process may then be such that the aqueous printing or coating ink (solution, dispersion), will be deposited only in the non-hydrophobic areas, so as to provide a suitable electrical coupling to the contact pads without a risk of creating short-circuits. It is furthermore possible to apply first selectively a hydrophobic layer, so as to increase the thickness of the protective and electrically insulating barrier between neighbouring contacts.

When depositing or printing a material before the local removal of the protective layer, a suitable material is for instance a resist, solder resist or a surface modification or the like. A resist or solder resist (or another electrically insulating layer) may be used to increase the thickness of the protective layer, so that the protective layer can serve as an electrically insulating barrier, which also defines a distance between the one or more electronic component to be applied and the interconnect foil. The material may further contribute to the mechanical attachment of the one or more electronic components to the interconnect foil, e.g. as known in general from flip-chip assembly technology. When applying such a resist or solder resist, use could be made of typical photolithographical techniques, i.e. by treatment to achieve a conversion and thereafter remove certain portions with a suitable solvent. Alternatively or additionally, the laser could be used to remove both the resist and the protective layer locally. A surface modification may be used to tune the surface properties of the protective layer, particularly so as to enable selective materials deposition in a subsequent stage. Such layers are typically relatively thin.

Evidently, when using the access window as a lateral border for deposition or printing of materials, it is deemed beneficial that the mobile carrier table is positioned such that the interconnect foil is present at its bottom side. This is preferably carried out, in one embodiment after passing a subsequent station in the assembly line called a turn unit. When the printing or deposition step precedes the local removal of the protective layer, another turn unit may present between such printing or deposition step and the local removal of the protective layer.

In a third step of the method, the mobile carrier table 20 moves to the processing unit 130 for application of the first foil 6 of encapsulant material, such as ethylene-vinyl acetate, also known as EVA. Other examples will be apparent to the skilled person. The processing unit unwinds the first foil, directly from a roll, cuts the first foil on a preset length and presents the first foil on a pick-up table 131. The first foil 6 will be automatically picked up by means of a vacuum head and will be provided with through-holes on a step-by-step punching process. The pattern of through-holes exactly matches the grid of the contact pads, provided on the interconnect foil 4. After making of the through-holes, the first foil 6 will be deposited upon the interconnect foil 4, leaving the conductive adhesive or solder paste free. It is important to observe that the pick-up table 131, also referred to as the vacuum carrier, provides vacuum locally. It includes pins or similar means for carrying out the punching process, which extends through the vacuum carrier 131. The local vacuum is not present at the location of such pins. Thereto, the vacuum carrier suitably comprises vacuum chambers and a venturi system for the generation of the vacuum.

In a subsequent step, the carrier table moves towards the cell placing unit (not shown so as to keep the figure limited in size), which is provided with, in this embodiment, two robots. Each of the robots will pick up the solar cells out of one common cartridge. The cell placing unit is provided with a couple of cartridges, offering a buffer for solar cells. Picking up takes place with use of a Bernoulli nozzle system in order to reduce breakage. Each individual solar cell passes a digital vision system which will image the cells on the contact pads for optical alignment. Depending on the results, the robots will receive re-calculated coordinates for deposition of the cells on the first foil. During optical alignment, the digital vision system will also inspect the cells on breakage (by imaging at least a part of the outer edges) and possible shifting printing patterns. By this process, the cells are touched only one time, thus reducing possible risk on breakage. Due to very careful handling, solar cells down to 130 micron thickness can be processed. Evidently, also solar cells with a larger thickness may be processed, for instance in the range up to 300 microns. It is not excluded that solar cells with a substrate thickness that is even further reduced, can be processed. Discarded cells will be collected into an empty cartridge for further inspection by the operator.

After placement of the cells upon the first foil 6, the carrier table moves through an optical inspection station (not shown), which checks on missing cells, alignment of cells and broken corners of cells. As soon as a problem is detected, the stack of foils is discarded out of the assembly line and placed on one of four repair stations. Above each repair station, a monitor is mounted, showing the problem spot for that particular stack of foils. After manual repair, the stack of foils is brought back into the assembly line at first possibility.

Subsequently, the moving carrier table 20 moves towards a unit for providing another foil (not shown. In this processing unit, the second foil 10 of encapsulant material is provided. This comprises the steps of unwinding the second foil, directly from a roll, cutting the second foil on a present length and presenting the second foil on a pick-up table. The second foil will be automatically picked up by means of a vacuum head which will deposit the second foil on top of the first foil and the solar cells.

The carrier table 20 advances towards the glass placing unit 140, which is connected with a glass unpiling robot or glass washing machine. The glass sheet 11 will be aligned based on the centre of the glass, which averages possible differences in glass size. Alternatively, this can be carried out manually. After alignment, a vacuum pick&place unit 141 takes the glass 11 and places it on the second foil 10.

Thereafter, the carrier table 20 is moved to a subsequent station 150, in which a preheating step is carried out. The pre-heating is in this embodiment generated by increasing the temperature in a kiln or heater station 152, for instance to 60-110°C, which is dependent on the type of materials of the first foil 6 and the second foil 10. This station 150 may further include a tester 151 that acts onto some of the contact pads of the interconnect foil 20 through the access window 21, so as to test the semi-manufactured solar panel 30 electrically. In this manner, it can be verified that a good connection has been generated between the solar cells 8 and the interconnect foil 4. It is observed for clarity that a vacuum generator could be left out in this station, since the pre-heating step serves to couple the foils together. However, it is not excluded either that a vacuum generator is present.

Subsequently, the carrier table proceeds towards the turn unit. Here, a clamp belt system turns upon the carrier table. As the solar panel is in between the belt and the carrier t able, it will be clamped. The turn unit takes the complete package and flips it over for 180°. The carrier table, which is now on top of the solar panel, will be lifted and finally, the clamp belt system conveys the solar panel out of the system, whereby the glass sheet is below and allows ease of transportation.

It is not excluded that the carrier table constitutes a portion of the resulting solar panel. In this embodiment, a glass plate or a ceramic or optionally polymer plate is suitably used as the carrier table. Then a turning around is not deemed necessary. A heat-conductive ceramic plate may be advantageous so as to enable heat dissipation during use. However, it has the disadvantage of relatively high weight and possible breakage. A polymer plate, such as an insert moulded body is less heavy, but needs to be sufficiently thermally stable for the lamination process. Moulding compounds with sufficient thermal stability are however thermally available.

In a further step, the one or more modules of electronic components are assembled onto the interconnect foil. The modules are placed in a flip-chip orientation, with the carrier pads of the module and the interconnect foil facing each other. A test of the electric connection between the contact pads may be carried out using one of the other contact pads as a test pad. This can be done either prior to lamination or after lamination. Such testing prior to lamination may be suitable so as to ensure correct placement of the solar cells relative to the interconnect foil. There is no need that the test and assembly of the (module of) electronic component(s) is carried out together. Particularly the test may be carried out prior to lamination, even though said assembly occurs only after lamination.

Suitably the modules of electronic components have been pre-tested as well. Use can be made of soldering or electrically conductive adhesive or the like for establishing the connection between carrier pads of the module and contact pads of the interconnect foil. The modules may be applied either before or after the removal of the carrier table 7. The modules may further be applied either before or after any of the further steps described hereinafter, and particularly lamination. Rather than applying modules, the through-holes exposing contact pads on the second side of the interconnect foil could be used for the provision of an electrical coupling between sections within the solar panel or for the provision of an electrical coupling to a terminal, or for the provision of another electrical coupling.

The solar panel is now available for further finalisation, like lamination, trimming, framing, flash-testing and sorting. The empty carrier table descends by a descend lift unit and moves back towards the entry of the line on a second transportation level. This level also buffers empty carrier tables which are not in use. At the entry of the line, an ascend lift unit brings the carrier tables back to the normal process height for a next round.

In summary, the present invention provides a method of manufacturing a solar panel and a resulting solar panel. The solar panel is manufactured by provision of a stack of foils on top of a carrier table. Individual solar cells are provided between a first and a second foil of thermoplast material. An interconnect foil is present between the first foil and the carrier table, connections to the solar cells extending through the first foil. At least one electronic component, suitably part of a module, is or can be integrated into the solar panel. Thereto, a protective layer of the interconnect foil is locally removed by means of optical removal means, such as a laser.

## Claims

1. A method of assembling of a solar panel (30), wherein a plurality of solar cells (8) is assembled to a first side (41) of a interconnect foil (4) comprising a pattern of electrical conductors, the pattern being provided with some contact pads (16, 44), which interconnect foil (4) is provided with a protective layer (43) on a second side (42) facing away from the solar cells (8), comprising the steps of:
- applying the interconnect foil (4) onto a carrier table (20) provided with an access window (21);
- locally removing the protective layer (43) through the access window (21) so as to expose at least one of said contact pads (44) of the interconnect foil (4), and
- assembling at least one electronic component (50) to the second side (42) of the interconnect foil(4), contact pads (54) of the component (50) being coupled to corresponding ones of said exposed contact pads (44) of the interconnect foil (4).

2. The method as claimed in claim 1, comprising the steps of applying a further foil (6) to the first side (41) of the interconnect foil (4), which is provided with holes (7) at predefined locations, and assembling the solar cells (8), such that contact pads (9) of the solar cells (8) are coupled to the interconnect foil (4) through the holes (7) in the further foil (6).

3. The method as claimed in claim 1 or 2, wherein the protective layer (43) is locally removed prior to the assembly of the solar cells (8).

4. The method of claim 1 or 2, wherein the carrier table (20) is a mobile carrier table that is movable between a first assembly station (110) and a second position, preferably a second assembly station (120, 130, 140, 150).

5. The method of claim 1-4, wherein the removal of the protective layer (43) is carried out optically, preferably by using a laser (121).

6. The method of claim 1-5, wherein lateral positions of the contact pads (44) are detected optically through the access window (21) prior to the local removal of the protective layer (43).

7. The method of claim 1-6, wherein a material is deposited or printed through the access window (21) onto the contact pads (44) and/or the protective layer (43).

8. The method as claimed in Claim 1-6, wherein the assembly of solar cells (8) and interconnect foil (4) is tested through at least one of the exposed contact pads (44) prior to assembly of the electronic component (50).

9. A solar panel (30) comprising:
- a plurality of solar cells (8) provided with contact pads (9);
- an interconnect foil (4) with a first side and a second side and comprising a pattern of electrical conductors, the pattern being provided with some contact pads (16,44), which interconnect foil is provided with a protective layer (43) on the second side;
- on the first side of the interconnect foil, a first foil (6) of encapsulant material provided with through-holes aligned with contact pads (16) on the interconnect foil (4) and contact pads (9) on the solar cells (8), and thereon a second foil (10) of encapsulant material and a cover plate, wherein the plurality of solar cells (8) is present between the first foil (6) and the second foil (10) and are assembled to the first side (41) of the interconnect foil (4), and wherein the contact pads (9) of the solar cells (8) are electrically connected to aligned contact pads (16) of the interconnect foil (4) via the through-holes in the first foil (4) by means of electrically conductive material (17),
**characterized in that**:
- the solar panel further comprises at least one electronic component (50), which is provided with contact pads (54),
- the protective layer (43) is patterned with through-holes (45) so as to expose contact pads (44) on the second side of the interconnect foil (4), wherein a portion (43A) of the protective layer (43) is retained between neighbouring through-holes (45),
- electrically conductive material (51) establishes a connection between the at least one electronic component (50) and the contact pads (44) of the interconnect foil (4).

10. The solar panel as claimed in Claim 9, wherein the at least one electronic component is a module of electronic components.

11. The solar panel as claimed in Claim 9 or 10, wherein the electrically conductive material (51) for the connection with the electronic component is solder or electrically conductive adhesive.

## Patentansprüche

1. Verfahren zum Zusammenfügen eines Solarpanels (30), wobei mehrere Solarzellen (8) mit einer ersten Seite (41) einer ein Muster von elektrischen Leitern umfassenden Verbindungsfolie (4) zusammengefügt werden, wobei das Muster mit einigen Kontaktpads (16, 44) versehen ist, die Verbindungsfolie (4) mit einer Schutzschicht (43) auf einer zweiten Seite (42) versehen ist, die von den Solarzellen (8) weg weist, wobei das Verfahren umfasst:
- Aufbringen der Verbindungsfolie (4) auf einen Trägertisch (20), der mit einem Zugangsfenster (21) versehen ist;
- lokales Entfernen der Schutzschicht (43) durch das Zugangsfenster (21), so dass wenigstens eines der Kontaktpads (44) der Verbindungsfolie (4) freigelegt wird, und
- Zusammenfügen von wenigstens einer elektronischen Komponente (50) mit der zweiten Seite (42) der Verbindungsfolie (4), wobei Kontaktpads (54) der Komponente (50) mit entsprechenden der freigelegten Kontaktpads (44) der Verbindungsfolie (4) gekoppelt werden.

2. Verfahren gemäß einem der Ansprüche 1, umfassend die Schritte des Aufbringens einer weiteren Folie (6) an der ersten Seite (41) der Verbindungsfolie (4), die mit Löchern (7) an vordefinierten Stellen versehen ist, und des Zusammenfügens der Solarzellen (8), so dass Kontaktpads (9) der Solarzellen (8) mit der Verbindungsfolie (4) durch die Löcher (7) in der weiteren Folie (6) gekoppelt werden.

3. Verfahren gemäß einem der Ansprüche 1 oder 2, wobei die Schutzschicht (43) vor dem Zusammenfügen der Solarzellen (8) lokal entfernt wird.

4. Verfahren gemäß einem der Ansprüche 1 oder 2, wobei der Trägertisch (20) ein mobiler Trägertisch ist, der zwischen einer ersten Fügestation (110) und einer zweiten Position, bevorzugt einer zweiten Fügestation (120, 130, 140, 150), bewegbar ist.

5. Verfahren gemäß einem der Ansprüche 1 bis 4, wobei das Entfernen der Schutzschicht (43) optisch, bevorzugt unter Verwendung eines Lasers (121), durchgeführt wird.

6. Verfahren gemäß einem der Ansprüche 1 bis 5, wobei laterale Positionen der Kontaktpads (44) optisch durch das Zugangsfenster (21) vor dem lokalen Entfernen der Schutzschicht (43) detektiert werden.

7. Verfahren gemäß einem der Ansprüche 1 bis 6, wobei ein Material durch das Zugangsfenster (21) auf die Kontaktpads (44) und/oder die Schutzschicht (43) abgeschieden oder gedruckt wird.

8. Verfahren gemäß einem der Ansprüche 1 bis 6, wobei das Zusammenfügen der Solarzellen (8) und Verbindungsfolie (4) durch wenigstens eines der freigelegten Kontaktpads (44) vor Zusammenfügen der elektronischen Komponente (50) getestet wird.

9. Solarpanel (30), umfassend:
- mehrere Solarzellen (8), die mit Kontaktpads (9) versehen sind;
- eine Verbindungsfolie (4) mit einer ersten Seite und einer zweiten Seite und ein Muster von elektrischen Leitern umfassend, wobei das Muster mit einigen Kontaktpads (16, 44) versehen ist, und die Verbindungsfolie mit einer Schutzschicht (43) auf der zweiten Seite versehen ist;
- auf der ersten Seite der Verbindungsfolie, eine erste Folie (6) von Verkapselungsmaterial, die mit Durchgangslöchern (7) versehen ist, die mit Kontaktpads (16) auf der Verbindungsfolie (4) und Kontaktpads (9) auf den Solarzellen (8) fluchten, und darauf eine zweite Folie (10) von Verkapselungsmaterial und einer Deckplatte (11), wobei die mehreren Solarzellen (8) zwischen der ersten Folie (6) und der zweiten Folie (10) angeordnet sind und mit der ersten Seite (41) der Verbindungsfolie (4) zusammengefügt sind, und wobei die Kontaktpads (9) der Solarzellen (8) mit den fluchtenden Kontaktpads (16) der Verbindungsfolie (4) über die Durchgangslöcher in der ersten Folie (6) mittels eines elektrisch leitenden Materials (17) elektrisch verbunden sind,
**dadurch gekennzeichnet, dass**:
- das Solarpanel ferner wenigstens eine elektronische Komponente (50) umfasst, die mit Kontaktpads (54) versehen ist,
- die Schutzschicht (43) mit Durchgangslöchern (45) gemustert ist, so dass Kontaktpads (44) auf der zweiten Seite der Verbindungsfolie (4) freigelegt sind, wobei ein Abschnitt (43a) der Schutzschicht (43) zwischen benachbarten Durchgangslöchern (45) beibehalten ist,
- elektrisch leitendes Material (51) eine Verbindung zwischen der wenigstens einen elektronischen Komponente (50) und den Kontaktpads (44) der Verbindungsfolie (4) herstellt.

10. Solarpanel gemäß Anspruch 9, wobei die wenigstens eine elektronische Komponente ein Modul von elektronischen Komponenten ist.

11. Solarpanel gemäß Anspruch 9 oder 10, wobei das elektrisch leitende Material (51) für die Verbindung mit der elektronischen Komponente Lötmetall oder elektrisch leitendes Klebemittel ist.

## Revendications

1. Procédé d'assemblage d'un panneau solaire (30), dans lequel une pluralité de cellules solaires (8) est assemblée sur une première face (41) d'une feuille d'interconnexion (4) comprenant un circuit de conducteurs électriques, le circuit comportant un certain nombre de plots de contact (16, 44), laquelle feuille d'interconnexion (4) comporte une couche de protection (43) sur une seconde face (42) à l'opposé des cellules solaires (8), comprenant les étapes de:
- application de la feuille d'interconnexion (4) sur une table de maintien (20) comportant une fenêtre d'accès (21) ;
- élimination locale de la couche de protection (43) à travers la fenêtre d'accès (21) de manière à exposer au moins l'un desdits plots de contact (44) de la feuille d'interconnexion (4), et
- assemblage d'au moins un composant électronique (50) sur la seconde face (42) de la feuille d'interconnexion (4), des plots de contact (54) du composant (50) étant couplés à certains correspondants desdits plots de contact exposés (44) de la feuille d'interconnexion (4).

2. Procédé selon la revendication 1, comprenant les étapes d'application d'une autre feuille (6) sur la première face (41) de la feuille d'interconnexion (4), qui comporte des orifices (7) à des emplacements prédéfinis et d'assemblage des cellules solaires (8), de telle sorte que les plots de contact (9) des cellules solaires (8) sont couplés à la feuille d'interconnexion (4) à travers les orifices (7) sur l'autre feuille (6).

3. Procédé selon la revendication 1 ou 2, dans lequel la couche de protection (43) est éliminée localement avant l'assemblage des cellules solaires (8).

4. Procédé selon la revendication 1 ou 2, dans lequel la table de maintien (20) est une table de maintien mobile qui peut être déplacée entre un premier poste d'assemblage (110) et une seconde position, de préférence, un second poste d'assemblage (120, 130, 140, 150).

5. Procédé selon les revendications 1 à 4, dans lequel l'élimination de la couche de protection (43) est mise en oeuvre de manière optique, mais, de préférence, en utilisant un laser (121).

6. Procédé selon les revendications 1 à 5, dans lequel les positions latérales des plots de contact (44) sont détectés de manière optique à travers la fenêtre d'accès (21) avant l'élimination locale de la couche de protection (43).

7. Procédé selon les revendications 1 à 6, dans lequel un matériau est déposé ou imprimé à travers la fenêtre d'accès (21) sur les plots de contact (44) et/ou la couche de protection (43).

8. Procédé selon les revendications 1 à 6, dans lequel l'assemblage des cellules solaires (8) et de la feuille d'interconnexion (4) est testé par l'intermédiaire d'au moins l'un des plots de contact exposés (44) avant l'assemblage du composant électronique (50).

9. Panneau solaire (30) comprenant :
- une pluralité de cellules solaires (8) comportant des plots de contact (9) ;
- une feuille d'interconnexion (4) avec une première face et une seconde face et comprenant un circuit de conducteurs électriques, le circuit comportant certains plots de contact (16, 44), laquelle feuille d'interconnexion comporte une couche de protection (43) sur la seconde face ;
- sur la première face de la feuille d'interconnexion, une première feuille (6) de matériau d'enrobage comportant des orifices traversant (7) alignés avec des plots de contact (16) sur la feuille d'interconnexion (4) et des plots de contact (9) sur les cellules solaires (8), et sur celle-ci une seconde feuille (10) de matériau d'enrobage et une plaque de revêtement (11),
- dans lequel la pluralité de cellules solaires (8) est présente entre la première feuille (6) et la seconde feuille (10) et elles sont assemblées sur la première face (41) de la feuille d'interconnexion (4), et dans lequel les plots de contact (9) des cellules solaires (8) sont raccordés électriquement à des plots de contact alignés (16) de la feuille d'interconnexion (4) par l'intermédiaire des orifices traversant sur la première feuille (6) au moyen de matériau électriquement conducteur (17),
**caractérisé en ce que** :
- le panneau solaire comprend en outre au moins un composant électronique (50), qui comporte des plots de contact (54),
la couche de protection (43) est façonnée avec des orifices traversant (45) de manière à exposer des plots de contact (44) sur la seconde face de la feuille d'interconnexion (4), dans lequel une partie (43A) de la couche de protection (43) est retenue entre des orifices traversant (45) voisins,
le matériau électriquement conducteur (51) établit une liaison entre le ou les composants électroniques (50) et les plots de contact (44) de la feuille d'interconnexion (4).

10. Panneau solaire selon la revendication 9, dans lequel l le ou les composants électroniques sont constitués par un module de composants électroniques.

11. Panneau solaire selon la revendication 9 ou 10, dans lequel le matériau électriquement conducteur (51) destiné à assurer la liaison avec le composant électronique est une soudure ou un adhésif électriquement conducteur.
